Europäisches Patentamt

European Patent Office

Office européen des brevets

(19)

(11) Numéro de publication : **0 130 871**
**B1**

(12) **FASCICULE DE BREVET EUROPÉEN**

(45) Date de publication du fascicule du brevet :
23.12.87

(51) Int. Cl.⁴ : **H 01 J 9/227**, G 03 F 7/16

(21) Numéro de dépôt : **84401209.6**

(22) Date de dépôt : **13.06.84**

(54) **Procédé de fabrication d'un tube de télévision en couleurs à faible réflectance de l'écran pour la lumière ambiante.**

(30) Priorité : **24.06.83 FR 8310498**

(43) Date de publication de la demande :
**09.01.85 Bulletin 85/02**

(45) Mention de la délivrance du brevet :
**23.12.87 Bulletin 87/52**

(84) Etats contractants désignés :
**AT DE FR GB IT NL**

(56) Documents cités :
**EP-A- 0 077 976**
**DE-A- 1 904 928**
**DE-A- 2 131 582**
**PATENTS ABSTRACTS OF JAPAN, vol. 6, no. 81(E-107)(959), 19 mai 1982**

(73) Titulaire : **VIDEOCOLOR**
**7, boulevard Romain-Rolland**
**F-92128 Montrouge (FR)**

(72) Inventeur : **Pezzulo, Antimo**
**THOMSON-CSF SCPI - 173 bld Haussmann**
**F-75379 Paris Cedex 08 (FR)**
Inventeur : **Di Passio, Attilio**
**THOMSON-CSF SCPI - 173 bld Haussmann**
**F-75379 Paris Cedex 08 (FR)**

(74) Mandataire : **Grynwald, Albert et al**
**THOMSON-CSF SCPI 19, avenue de Messine**
**F-75008 Paris (FR)**

## Description

L'invention est relative à un procédé de fabrication d'un tube de télévision en couleurs à faible réflectance de l'écran.

L'écran d'un tube de télévision en couleurs est formé principalement de bandes verticales de luminophores destinés à émettre de la lumière de couleurs, respectivement rouge, verte et bleue, lorsqu'ils sont excités par des faisceaux d'électrons produits par les canons à l'intérieur du tube. Ces bandes luminescentes ne sont habituellement pas jointives ; elles sont séparées par des bandes neutres, c'est-à-dire dépourvues de luminophore. L'ensemble de ces bandes est recouvert d'une couche d'aluminium qui permet, notamment, de réfléchir vers l'avant, c'est-à-dire vers le spectateur, la lumière émise vers l'arrière par les luminophores. Mais cette couche d'aluminium constitue dans les zones neutres un miroir qui réfléchit la lumière ambiante et qui, ainsi altère la qualité — surtout le contraste — de l'image. Pour remédier à cet inconvénient, on dépose, entre les bandes de luminophores, avant la formation de la couche d'aluminium, une couche noire antiréfléchissante, notamment en graphite. Cette opération de dépôt de couche noire, à laquelle se rapporte l'invention, est appelée « procédé Matrix » — voir, par exemple, EP-A-0 077 976.

La couche noire antiréfléchissante· est également déposée sur la face interne du rebord, ou jupe, de la dalle (partie avant du tube sur laquelle est formé l'écran) qui raccorde cette dalle à la partie conique du tube. En effet, des reflets de la lumière ambiante sur ce rebord pourraient être gênants pour le spectateur surtout lorsque ce rebord est apparent, c'est-à-dire extérieur à l'ébénisterie du récepteur de télévision.

On a constaté que le procédé connu de formation de la couche noire antiréfléchissante donnait parfois des résultats peu satisfaisants, le dépôt n'étant pas toujours régulier, pouvant même présenter des cloques ou craquelures. De plus, cette couche noire n'est pas suffisamment épaisse.

L'invention perfectionne le procédé connu de façon à remédier à cet inconvénient. Elle fournit donc sur la face interne du rebord de la dalle une couche noire antiréfléchissante régulière et épaisse ; en outre le procédé selon l'invention est peu onéreux_ et aisément utilisable pour une fabrication en grande série.

Pour bien comprendre l'invention, avant d'exposer le perfectionnement, on rappelle tout d'abord comment est réalisé le procédé connu de formation des couches antiréfléchissantes.

La face interne du panneau avant (dalle et son rebord) du tube est d'abord lavée et séchée.

Puis, on applique sur cette face interne une substance photosensible appelée « photorésist » qui présente la propriété de durcir lorsqu'elle est illuminée par un rayonnement ultraviolet (UV) et, si elle n'a pas été illuminée, de pouvoir être éliminée par lavage à l'eau. La substance photosensible déposée est ensuite séchée, puis on expose aux rayonnements UV les zones de cette substance qui sont situées aux futurs emplacements des bandes luminescentes ; on procède ensuite au développement à l'eau. Il ne reste alors sur la face interne de la dalle que des bandes durcies aux emplacements où seront déposées ultérieurement les bandes de phosphores. Du graphite en suspension dans l'eau est ensuite appliqué sur la face interne du panneau avant. Ce graphite recouvre donc à la fois les bandes de matière photosensible durcie, le verre en principe à nu entre ces bandes, ainsi que le rebord.

Après séchage, on projette une solution oxydante à base d'eau oxygénée $H_2O_2$ dont le but est d'attaquer chimiquement la substance photosensible durcie restant sur le verre, sous la couche de graphite. Enfin après un dernier développement, qui consiste à injecter de l'eau sous pression, le photorésist durci qui a été attaqué chimiquement par la solution oxydante se détache du verre, emmenant avec lui le graphite qui le recouvre. Il ne reste, alors, sur la dalle et sur le rebord que du graphite aux endroits voulus, c'est-à-dire aux emplacements entre les bandes de phosphores et sur rebord.

L'invention repose sur l'hypothèse que la qualité médiocre du dépôt de graphite sur le rebord a l'origine suivante : lors de l'exposition au rayonnement ultraviolet, de la lumière diffusée atteint ce rebord, ce qui provoque la formation d'une mince couche, ou pellicule, de photorésist durci sur ce rebord. Cette pellicule n'est pas régulière et peut présenter des cloques, bulles ou craquelures, inesthétiques pour le spectateur après dépôt du graphite. Enfin lors de la dernière opération de développement, la solution oxydante attaque cette pellicule, ce qui altère la couche de graphite qui la recouvre.

Pour remédier à cet inconvénient, c'est-à-dire pour obtenir une couche de graphite d'excellente qualité sur le rebord, l'invention telle qu'elle est caractérisée dans la revendication 1 prévoit des moyens pour rendre uniforme, et de préférence plus fine, la pellicule de substance photosensible durcie sur le rebord et/ou des moyens, déposés après l'application du graphite, qui permettent de réduire, ou annuler, l'effet de la solution oxydante sur la pellicule de substance photosensible durcie restant sur le rebord.

Dans une réalisation, avant l'application de la substance photosensible on projette de l'eau, de préférence déionisée, sur le rebord. On a constaté qu'avec cette disposition le photorésist adhère plus aisément au verre et on produit ainsi sur le rebord, après l'illumination UV, une pellicule de substance photosensible plus uniforme et peut être plus fine. Autrement dit, la pellicule de substance photosensible durcie ne présente pas de cloques ou craquelures comme c'est le cas avec le procédé de la technique antérieure.

On peut également utiliser de l'eau, de préférence déionisée, projetée sur la couche de graphite séchée, avant l'application de la solution oxydante (par exemple à base d'eau oxygénée), afin de réduire l'activité de cette solution oxydante sur la pellicule de photorésist durcie déposée sur le rebord, sous le graphite.

D'autres caractéristiques de l'invention apparaîtront avec la description de l'un des ses modes de réalisation, celle-ci étant effectuée en se référant aux dessins ci-annexés sur lesquels :

la figure 1 illustre une étape du procédé selon l'invention,

les figures 2 à 4 sont des schémas montrant d'autres étapes, classiques, du procédé de dépôt de graphite sur la face interne du panneau avant d'un tube de télévision en couleurs,

la figure 5 montre une étape du procédé selon l'invention et

la figure 6 est un schéma dudit panneau après la mise en œuvre du procédé de l'invention.

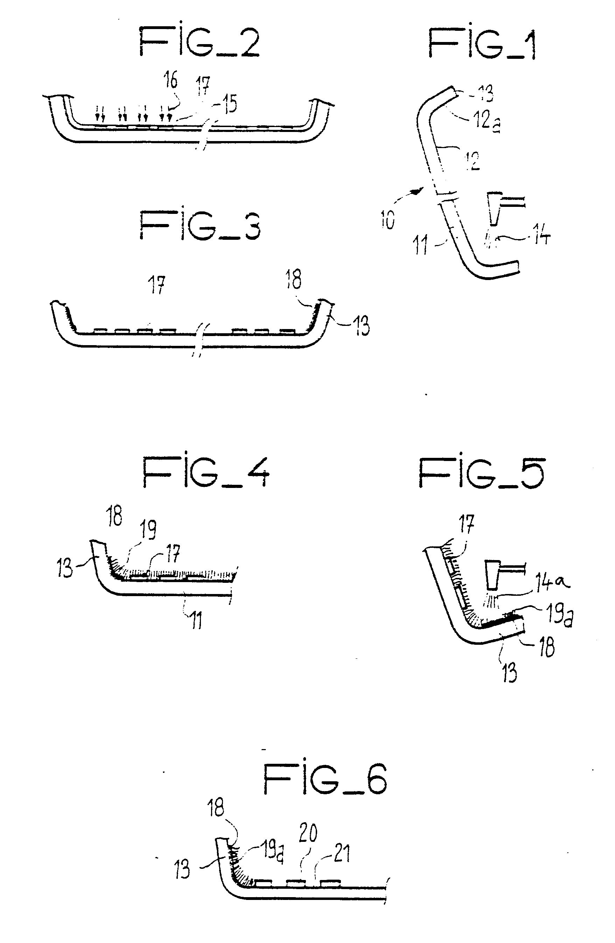

Le panneau avant 10 (figure 1) d'un tube de télévision en couleurs est constitué par une dalle 11 sur la face interne 12 de laquelle sont déposées les substances luminescentes, ainsi que par un rebord 13 destiné à être raccordé à la partie conique (non représentée) du tube.

Pour la fabrication de l'écran, on procède d'abord au lavage et au séchage du verre, encore à nu, du panneau 10. Ensuite selon l'invention, on projette de l'eau déionisée 14 (figure 1) sur la face interne 12a du rebord 13.

Après cette projection d'eau déionisée 14 sur la face interne du rebord 13 on applique une solution de matière photosensible 15 (figure 2) sur les faces internes 12 et 12a. Ce photorésist 15 est ensuite séché puis exposé, de façon en soi connue, à de la lumière ultraviolette (UV) 16 aux emplacements où seront déposés ultérieurement les luminophores. Les parties 17 du photorésist qui ont été exposées au rayonnement ultraviolet 16 sont alors durcies et insolubles dans l'eau.

On procède ensuite au développement de la substance photosensible 15 qui consiste à projeter de l'eau sur les faces internes 12 et 12a. Il ne reste alors (figure 3) que les zones 17 qui ont été illuminées. Toutefois les inventeurs ont constaté qu'il subsiste, malgré tout, une mince couche ou pellicule 18 de matière photosensible durcie aux emplacements qui n'ont pas été illuminés volontairement, notamment sur la face interne 12a du rebord 13. Cette pellicule 18, plus mince que les bandes 17, est probablement due à une diffusion, presque inévitable, de lumière ultraviolette vers le rebord. Cependant avec le mouillage préalable de ladite face interne 12a du rebord 13 à l'aide d'eau déionisée 14 cette pellicule 18 est, par rapport à une pellicule obtenue sans projection préalable d'eau déionisée, plus uniforme et probablement plus mince.

De plus, le jet d'eau déionisée 14 (figure 1) permet, par rapport à la technique antérieure, d'éviter la formation, dans la pellicule 18, de bulles ou craquelures qui sont, après application ultérieure de graphite, inesthétiques pour le spectateur.

Après développement de la matière photosensible, on répand une suspension de graphite noir sur les surfaces 12 et 12a recouvertes des bandes 17 et de la pellicule 18.

Cette suspension est ensuite séchée et on obtient un dépôt de graphite 19 (figure 4) sur la face interne du panneau 10, à la fois sur les bandes 17 et entre celles-ci.

Après ce séchage, selon l'invention, on projette de nouveau de l'eau déionisée 14a (figure 5) sur la couche 19a de graphite recouvrant la face interne du rebord ou jupe 13.

Ensuite une solution d'eau oxygénée $H_2O_2$ est appliquée sur les faces internes 12 et 12a pour détruire, par attaque chimique, les bandes 17 de substance photosensible. Après un développement qui consiste en un lavage à l'eau sous pression, ces bandes 17 sont entraînées par le jet d'eau et entraînent avec elles le graphite qui les recouvre. Il ne reste ainsi sur la dalle que les bandes de graphite 20 (figure 6) déposées entre les bandes 17, c'est-à-dire entre les emplacements 21 où seront déposés ultérieurement les phosphores. La couche 19a de graphite sur le rebord 13 reste de bonne qualité grâce à la projection d'eau déionisée 14a qui a permis, par dilution et par refroidissement, de réduire l'activité chimique de l'eau oxygénée sur la pellicule sousjacente 18 de photorésist.

**Revendications**

1. Procédé de dépôt d'une couche antiréfléchissante (19), notamment à base de graphite noir, entre les bandes de phosphores de l'écran d'un tube de télévision en couleurs et sur la face interne (12a) du rebord (13) du panneau avant (10) de ce tube, procédé dans lequel : on applique une substance photosensible (15) sur la face interne (12, 12a) du panneau (10), on expose cette substance (17) à un rayonnement (16) permettant de la durcir aux emplacements prévus pour les phosphores, les parties non durcies étant ensuite éliminées, après quoi la face interne (12, 12a) est recouverte de la couche antiréfléchissante, puis une solution oxydante est déposée sur ladite face interne du panneau de façon à détruire, par attaque chimique, les bandes durcies (17) et, enfin, on élimine ces bandes (17) détruites avec la couche antiréfléchissante qui les recouvre, caractérisé en ce qu'une pellicule (18) de matière photosensible durcie se formant sur la face interne (12a) du rebord (13) par suite d'une diffusion dudit rayonnement, on dépose seulement sur cette face (12a) du rebord, préalablement au dépôt de substance photosensible (15), un moyen (I4) permettant de rendre ladite pellicule durcie uniforme et/ou on projette seulement sur la couche (19a) antiréfléchissante se trouvant sur le rebord, avant l'application de la solution oxydante, un moyen (14a) permettant de réduire l'activité de cette solution oxydante sur la pellicule (18).

2. Procédé selon la revendication 1, caractérisé en ce que ledit moyen (14) pour rendre uniforme ladite pellicule (18) de matière photosensible durcie sur la face interne (12a) du rebord (13), est de l'eau, de préférence déionisée, qui est projetée sur ladite face.

3. Procédé selon la revendication 1 ou 2, caractérisé en ce que le moyen (14a) réduisant l'activité de la solution oxydante agit par dilution et/ou refroidissement.

4. Procédé selon la revendication 3, caractérisé en ce que le moyen (14a) réduisant l'activité de la solution oxydante qui agit par dilution et/ou refroidissement est de l'eau, de préférence déionisée, projetée sur la couche antiréfléchissante (19a) du rebord avant l'application de la substance oxydante.

## Claims

1. Method of depositing an antireflection layer (19), in particular on black graphite base, between the phospor strips of the screen of a color television tube and on the internal face (12a) of the edge (13) of the front panel (10) of this tube, wherein : a photosensitive substance (15) is applied on the internal face (12, 12a) of the panel (10), this substance (17) being exposed to a radiation (16) permitting to cure it at the intended locations of the phosphors, those portions not having been cured being subsequently eliminated, whereafter the internal face (12, 12a) is covered with the antireflection layer, then an oxidizing solution is deposited on said internal face of the panel in a manner to destroy the cured strips (17) by chemical attack, and finally these destroyed strips (17) are eliminated with the antireflection layer whereby they are covered, characterized in that, a film (18) of photosensitive cured material being formed on the internal face (12a) of the edge (13) as a consequence of a diffusion of said radiation, a means (14) permitting to render said cured film uniform is applied only on this face (12a) of the edge prior to the deposit of the photosensitive substance (15) and/or only on the antireflection layer (19a) located on the edge, a means (14a) permitting to reduce the activity of this oxidizing solution on the film (18) is sprayed prior to the application of the oxidizing solution.

2. Method according to claim 1, characterized in that said means (14) for rendering uniform said film (18) of cured photosensitive material on the internal face (12a) of the edge (13) is water which is preferably deionized and sprayed on said face.

3. Method according to claim 1 or 2, characterized in that the means (14a) reducing the activity of the oxidizing solution acts by dilution and/or cooling.

4. Method according to claim 3, characterized in that the means (14a) reducing the activity of the oxidizing solution which acts by dilution and/or cooling is water which is preferably deionized and sprayed on the antireflection layer (19a) of the edge prior to the application of the oxidizing substance.

## Patentansprüche

1. Verfahren zum Aufbringen einer Antireflexschicht (19), insbesondere auf Basis von schwarzem Graphit, zwischen die Leuchtstoffstreifen des Schirmes einer Farbfernsehröhre und auf die Innenseite (12a) des Randes (13) des vorderen Schildes (10) dieser Röhre, worin folgende Schritte ausgeführt werden : auf die Innenseite (12, 12a) des Schildes (10) wird eine fotosensible Substanz (15) aufgebracht, diese Substanz (17) wird einer Strahlung (16) ausgesetzt, die ihre Härtung an den für den Leuchtstoff vorgesehenen Stellen ermöglicht, die nicht gehärteten Teile werden anschließend entfernt, danach wird die Innenseite (12, 12a) mit der Antireflexschicht überzogen, dann wird eine oxidierende Lösung auf die Innenseite des Schildes so aufgetragen, daß sie durch chemischen Angriff die gehärteten Streifen (17) zerstört, und schließlich werden die zerstörten Streifen (17) mit der sie bedeckenden Antireflexschicht entfernt, dadurch gekennzeichnet, daß, da sich auf der Innenseite (12a) des Randes (13) durch die Streuung der Strahlung ein Film (18) aus gehärtetem, fotosensiblem Material bildet, nur auf diese Seite (12a) des Randes vor dem Aufbringen der fotosensiblen Substanz (15) ein Mittel (14) aufgetragen wird, das es ermöglicht, einen gleichmäßigen gehärteten Film zu erreichen, und/oder nur auf die Antireflexschicht (19a), die sich auf dem Rand befindet, vor dem Anwenden der oxidierenden Lösung ein Mittel (14a) gespritzt wird, das es ermöglicht, die Aktivität der oxidierenden Lösung auf den Film (18) zu verringern.

2. Verfahren nach Anspruch 1, dadurch gekennzeichnet, daß das Mittel (14) zum Erreichen eines gleichmäßigen Films (18) aus gehärtetem, fotosensiblem Material auf der Innenseite (12a) des Randes (13) vorzugsweise entionisiertes Wasser ist, das auf diese Seite gespritzt wird.

3. Verfahren nach Anspruch 1 oder 2, dadurch gekennzeichnet, daß das die Aktivität der oxidierenden Lösung vermindernde Mittel (14a) durch Verdünnung und/oder Abkühlung wirkt.

4. Verfahren nach Anspruch 3, dadurch gekennzeichnet, daß das die Aktivität der oxidierenden Lösung verringernde Mittel (14a), das durch Verdünnung und/oder Abkühlung wirkt, vorzugsweise entionisiertes Wasser ist, das auf die Reflexschicht (19a) des Randes vor der Anwendung der oxidierenden Substanz gespritzt wird.

FIG_2

FIG_1

FIG_3

FIG_4

FIG_5

FIG_6